# EUROPÄISCHE PATENTSCHRIFT

(11) **EP 0 838 987 B1**
(45) Veröffentlichungstag und Bekanntmachung des Hinweises auf die Patenterteilung: **01.12.1999**
(21) Anmeldenummer: 97117651.6
(22) Anmeldetag: 11.10.1997
(51) Int. Cl.: H05K 7/14, H05K 9/00

(54) **Baugruppenträger**
Electronic rack
Baie électronique

(30) Priorität: 25.10.1996 DE 19644420
(43) Veröffentlichungstag der Anmeldung: 29.04.1998
(73) Patentinhaber: Schroff GmbH, D-75334 Straubenhardt (DE)
(72) Erfinder: Günther, Hans-Ulrich, 76327 Pfinztal (DE); Mazura, Paul, 76302 Karlsbad (DE); Haag, Volker, 75323 Bad Wildbad (DE); Pfeifer, Klaus, 76199 Karlsruhe (DE); Thalau, Klaus-Michael, 76316 Malsch (DE); Joist, Michael, 76571 Gaggenau (DE); Weiss, Udo, 75334 Straubenhardt (DE)
(74) Vertreter: Durm, Klaus, Dr.-Ing.

(56) Entgegenhaltungen:
- EP-A- 0 038 652
- EP-A- 0 545 158
- EP-A- 0 596 349
- GB-A- 2 213 328
- US-A- 4 154 493

## Beschreibung

Die Erfindung betrifft einen Baugruppenträger für auf Führungsschienen einschiebbare Leiterkarten mit elektrischen oder elektronischen Bauelementen, mit zwei parallelen Seitenwänden und wenigstens vier parallel verlaufenden Modulschienen, welche die Seitenwände verbinden und die Führungsschienen tragen.

Insbesondere digitale elektronische Schaltungen, deren Schaltpegel zunehmend niedriger gewählt werden, reagieren empfindlich auf hochfrequente Störfelder in der Umgebung. Daher müssen Baugruppenträger mit Leiterkarten, die derartige empfindliche Schaltungen tragen, allseitig abgeschirmt sein. Zu diesem Zweck verwendet man hochfrequenzdichte Seitenwände, Deck- und Bodenbleche sowie rückwärtige Hauben. Die Abschirmung gegen hochfrequente Störfelder im Frontplattenbereich ist demgegenüber durch das Erfordernis, daß einzelne Leiterkarten jederzeit herausziehbar sein sollen, ungleich problematischer. Insbesondere wenn der Baugruppenträger nicht mit einer Gesamtfrontplatte versehen ist, die sich über die gesamte Breite des Baugruppenträgers erstreckt, sondern Steckbaugruppen aufnimmt, bei denen die eingeschobenen Leiterkarten mit einzelnen Frontplatten verbunden sind, bereiten die Spalte zwischen den Frontplatten und den Modulschienen besondere Probleme.

Die Abschirmung der vertikalen Spalte zwischen den einzelnen Frontplatten sowie zwischen den seitlichen Frontplatten und den Seitenwänden wird üblicherweise mit Federelementen vorgenommen, wie sie beispielsweise in der Patentschrift DE 41 10 800 C1 der Anmelderin beschrieben sind. Dort werden auf die Schenkel einer U-förmig ausgebildeten Frontplatte metallische Federelemente aufgesetzt, die sich beim Einschieben der Steckbaugruppe gegen die jeweils angrenzende Frontplatten oder gegebenenfalls gegen die Seitenwand des Baugruppenträgers pressen und so den erforderlichen, niederohmigen und flächigen Kontakt herstellen.

Die Abschirmung der horizontalen Spalte zwischen den Frontplatten und den Deck- und Bodenblechen wird unterschiedlich gehandhabt. Zumeist werden die Deck- und Bodenbleche mit den vier Modulschienen kontaktiert, welche jeweils in den Ecken der Seitenwände sitzen und die Seitenwände miteinander verbinden. Gleichzeitig wird auch für einen niederohmigen Kontakt zwischen den Frontplatten und den beiden vorderen Modulschienen gesorgt, so daß sich insgesamt eine vollständige Abschirmung ergibt.

Aus der DE 41 26 576 A1 ist ein Baugruppenträger mit Modulschienen bekannt, welche eine zur Vorderseite des Baugruppenträgers offene Nut zur Aufnahme eines Gewindelochstreifens und wenigstens eine Anlagefläche für die Frontplatte aufweisen. Dabei sind Federelemente vorgesehen, die in die offenen Nuten der Modulschienen eingeschoben werden und in vor dem Gewindelochstreifen angeordneten erweiterten Abschnitten der Nuten sitzen. Diese Federelemente weisen einen abgewinkelten Streifen auf, der über die Nuten der Modulschienen nach vorne übersteht und von den Frontplatten gegen eine elastische Federkraft in Richtung des Gewindelochstreifens eingeschoben wird.

Auch aus der DE 296 02 426 U1 ist ein Kontaktierungselement bekannt, welches in der nach vorne offenen Nut einer Modulschiene sitzt und vor dem Gewindelochstreifen angeordnet ist. Hier wird die Kontaktierung durch äquidistant angeordnete, nach vorne über die Modulschiene überstehende Kontaktdorne hergestellt.

Beim Kontaktieren der Frontplatten sowie der Deck- und Bodenbleche mit den Modulschienen des Baugruppenträgers ist aber darauf zu achten, daß der elektrische Kontakt nicht durch Oxidschichten beeinträchtigt wird. Dies gilt sowohl bei einem direkten Kontakt zwischen den Bauteilen als auch beim Verwenden eines zwischenliegenden Federelementes.

Modulschienen bestehen üblicherweise aus gezogenen Aluminiumprofilen, die mechanisch durch Sägen, Stanzen oder Bohren nachbearbeitet sind. Die natürliche Oxidhaut von unbehandeltem Aluminium ist sehr dünn, so daß die Oberfläche von gezogenen Aluminiumprofilen beim mechanischen Nachbearbeiten unvermeidlich verkratzt. Ferner kann die natürliche Oxidhaut nicht verhindern, daß unbehandelte Aluminiumprofile beim Transport oder bei der Lagerung ungleichmäßig weiter oxidieren, so daß sich eine insgesamt unschöne Oberfläche ausbildet. Um diesen Problemen zu entgegnen, werden die Aluminiumprofile direkt nach ihrer Herstellung üblicherweise eloxiert. Eine eloxierte Oberfläche kann ohne Verkratzen mechanisch nachbearbeitet werden.

Die elektrische Leitfähigkeit eines Kontaktes auf Aluminium mit natürlich aufgewachsener Oxidhaut ist zur Abschirmung gegen hochfrequente Wechselfelder ausreichend. Der Übergangswiderstand einer eloxierten Aluminiumoberfläche ist hingegen zu hoch. Daher werden nach dem Stand der Technik zwei unterschiedliche Arten von Baugruppenträgern angeboten: Einerseits Baugruppenträger ohne Abschirmung mit Modulschienen aus eloxiertem Aluminium und andererseits abgeschirmte Baugruppenträger, bei denen die ursprünglich eloxierten Modulschienen nach deren mechanischen Nachbearbeitung auf chemischem Wege in einer Lauge vollständig von ihrer Eloxalschicht befreit wurden. Dies bedingt hinsichtlich der Modulschienen eine doppelte Lagerhaltung beim Hersteller des Baugruppenträgers. Außerdem ist es kaum möglich, einen Baugruppenträger mit eloxierten Modulschienen nachträglich abzuschirmen.

Der Erfindung liegt daher die Aufgabe zugrunde, einen Baugruppenträger der eingangs genannten Art mit Modulschienen auszurüsten, welche eine widerstandsfähige Oberfläche besitzen, aber dennoch auf einfache Weise für den Einsatz in einem gegen hochfrequente Störfelder abgeschirmten Baugruppenträger angepaßt sind.

Diese Aufgabe ist mit einem Baugruppenträger mit den im Anspruch 1 genannten Merkmalen gelöst.

Vorteilhafte Ausgestaltungen und Weiterbildungen der Erfindung ergeben sich aus den Ansprüchen 2 bis 15.

Ein erfindungsgemäßer Baugruppenträger umfaßt also zwei parallele Seitenwände und wenigstens vier parallel verlaufende Modulschienen aus eloxiertem Aluminium oder einer eloxierten Aluminiumlegierung, welche die Seitenwände verbinden und Führungsschienen mit einschiebbaren und ausziehbaren Leiterkarten tragen, wobei an jeder vorderen Modulschiene wenigstens eine Anlagefläche für eine oder mehrere Frontplatten vorgesehen ist. Diese Anlageflächen sind erfindungsgemäß durch mechanisches Abtragen zumindest bereichsweise von ihrer Eloxalschicht befreit. Das mechanische Abtragen kann im einfachsten Fall durch Fräsen oder Schleifen erfolgt sein.

Der Baugruppenträger nach der Erfindung enthält also Modulschienen, welche ihre eloxierte Oberfläche im wesentlichen beibehalten und dennoch - durch einen unaufwendigen und einfachen mechanischen Bearbeitungsschritt - für Baugruppenträger verwendet werden können, die gegen hochfrequente Störfelder abgeschirmt sind. Beim Baugruppenträgerhersteller erübrigt sich daher sowohl die chemische Beseitigung von Eloxalschichten als auch die doppelte Lagerhaltung von Modulschienen. Gleichzeitig ergibt sich der Vorteil, daß die Modulschienen für abgeschirmte Baugruppenträger größtenteils eloxiert bleiben, wodurch ihre Oberfläche einheitlich und widerstandsfähig bleibt. Mit solchen Modulschienen ist selbst ein nachträgliches Abschirmen eines ursprünglich nicht abgeschirmten Baugruppenträgers möglich.

Besonders vorteilhaft ist es, wenn die eloxierten Modulschienen in den Bereichen, die mechanisch von der Eloxalschicht befreit werden sollen, Überhöhungen aufweisen. Durch mechanisches Abtragen dieser Überhöhungen kann die Eloxalschicht auf einfache Weise entfernt werden, ohne die Endmaße der Modulschienen zu verändern.

Zweckmäßig ist die Herstellung der Modulschienen als Strangpreßprofile. Bei der Herstellung von Strangpreßprofilen ist es insbesondere problemlos möglich, die erfindungsgemäßen Überhöhungen mit hoher Genauigkeit anzuformen. Durch einen kontinuierlichen mechanischen Abtrageprozeß, wie zum Beispiel kontinuierliches Fräsen, können diese Überhöhungen später mit ebenfalls hoher Genauigkeit auf einfache Weise egalisiert werden.

Zur Befestigung der Frontplatten an den Modulschienen können die vorderen Modulschienen je eine zur Vorderseite des Baugruppenträgers weisende offene Nut aufweisen. In diese Nut wird ein Gewindelochstreifen eingeschoben, in welchen Befestigungsschrauben für die Frontplattenstücke eingedreht werden können.

Besondere Vorteile bietet es, wenn auf die bereichsweise von ihrer Eloxalschicht befreiten Anlageflächen der vorderen Modulschienen Kontaktfederbänder aufsteckbar sind, welche den für eine Abschirmung gegen hochfrequente Störfelder notwendigen niederohmigen Kontakt sicherstellen. Solche aufsteckbaren Kontaktfederbänder können nachträglich auf die Anlageflächen aufgesetzt werden, um eine Abschirmung eines Baugruppenträgers auch später noch vornehmen zu können. Vorzugsweise besitzen die Kontaktfederbänder einen im wesentlichen U-förmigen Querschnitt mit nach innen abgebogenen Klemmrändern, so daß sie auf die Anlageflächen der Modulschienen aufgeschnappt werden können.

Wenn die Kontaktfederbänder aus einer Anzahl von jeweils gleichen Abschnitten bestehen, zwischen denen jeweils eine Sollbruchstelle angeordnet ist, können sie endlos hergestellt und zur hochfrequenzdichten Abschirmung eines Baugruppenträgers auf die jeweils erforderliche Länge gekürzt werden. Die Sollbruchstellen ermöglichen, daß die Kontaktfederbänder von Hand in der gewünschten Länge abgebrochen werden können.

Vorzugsweise befinden sich hinter den Anlageflächen der vorderen Modulschienen je eine obere Eingriffsnut und eine untere Eingriffsnut, wobei die Kontaktfederbänder durch beidseitiges Hintergreifen der Anlageflächen in die Eingriffsnuten einrasten. Wenn die Kontaktfederbänder im wesentlichen aus ebenen Metallblechen bestehen, deren obere und untere Ränder derart abgebogen sind, daß sie in die jeweiligen Eingriffsnuten der Modulschienen eingreifen, sorgt die Eigenelastizität der Metallbleche für den sicheren Halt der Kontaktfederbänder an den Modulschienen.

Vorteilhafterweise sind die Kontaktfederbänder mit einer Anzahl von Kontaktelementen versehen. Zweckmäßig bestehen diese Kontaktelemente aus federnd zur Vorderseite des Baugruppenträgers weisenden Ausbrechungen sowie aus zur Anlagefläche weisenden Kontaktkrallen. Die federnde Ausbildung der Ausbrechungen gewährleistet einerseits, daß die Frontplatten gegen eine Federkraft zur Modulschiene hin bewegt werden müssen. Die Ausbrechungen werden dabei elastisch verformt und dringen in die Oberfläche der [nnenseiten der Frontplatten ein, so daß ein sicherer elektrischer Kontakt hergestellt wird. Cleichzeitig werden die scharfkantigen Kontaktkrallen an den Rückseiten der Kontaktfederbänder gegen die Anlageflächen der Modulschienen gedrückt, wodurch die Kontaktierung mit den Modulschienen sichergestellt ist.

Die Ausbildung der Kontaktfederbänder durch ein ebenes Metallblech mit Ausbrechungen und Kontaktkrallen bringt noch weitere Vorteile mit sich, denn die Anlageflächen der vorderen Modulschienen dienen bei Baugruppenträgern, die mit Steckbaugruppen bestückt sind, gleichzeitig als Abdrückflächen von Aushebemechanismen für die Steckbaugruppen. Wenn sich nun beim Ausziehen von Steckbaugruppen, bei denen die Aushebekraft leicht 100 N und mehr betragen kann, der Aushebemechanismus auf den Anlageflächen der vorderen Modulschienen abstützt, können die aus einem ebenen Metallblech bestehenden Kontaktfederbänder nicht beschädigt werden. Eine geeignete Ausbildung der Ausbrechungen, zum Beispiel mit einem im wesentlichen vertikalen Einschnitt und zwei von diesem ausgehenden, dreieckförmig abgebogenen Federblättern, welche bis zum Anliegen an die Anlagefläche elastisch verformt werden können, kann auch verhindern, daß ein Aushebemechanismus die Ausbrechungen des Kontaktfederbandes beschädigt.

Die erfindungsgemäßen Modulschienen können neben den zu Kontaktierungszwecken bereichsweise blanken Anlageflächen für die Frontplatten auch zusätzlich mit Befestigungsnuten, beispielsweise für Deckplatten, versehen sein, deren Innenflächen ebenfalls zumindest bereichsweise von ihrer Eloxalschicht befreit sind und somit auch dort hervorragend kontaktieren.

Besondere fertigungstechnische Vorteile ergeben sich, wenn auch die Befestigungsnuten in den Bereichen, die mechanisch von der Eloxalschicht befreit werden sollen, mit Überhöhungen versehen sind. Diese Überhöhungen können weggefräst werden, wobei die Endmaße der Befestigungsnuten unverändert bleiben.

Eine zuverlässige Kontaktierung eines Deckblechs oder eines Bodenblechs in der Befestigungsnut einer Modulschiene wird vorzugsweise dadurch erreicht, daß klemmend in die Befestigungsnut einsetzbare Federelemente verwendet werden. Diese Federelemente stellen den für eine Abschirmung gegen hochfrequente Störfelder notwendigen niederohmigen Kontakt auch zwischen den Modulschienen und dem Deckblech oder Bodenblech sicher. Die Federelemente können nachträglich in die Befestigungsnuten eingesetzt werden, um eine Abschirmung eines Baugruppenträgers auch später noch vornehmen zu können.

Anhand der beigefügten Zeichnungen wird ein Ausführungsbeispiel der Erfindung im folgenden näher beschrieben. Es zeigen:
- Figur 1: eine schematische Ansicht eines Baugruppenträgers;
- Figur 2: ein Stück einer vorderen Modulschiene in perspektivischer Ansicht;
- Figur 3: ein Stück einer vorderen Modulschiene in seitlicher Ansicht;
- Figur 4: die Kontaktierung einer Modulschiene mit einer Frontplatte;
- Figur 5: eine Schnittdarstellung eines Kontaktfederbandes, welches auf eine Modulschiene aufgeschnappt wird;
- Figur 6: die Kontaktierung einer Modulschiene mit einer Frontplatte und der Deckplatte.

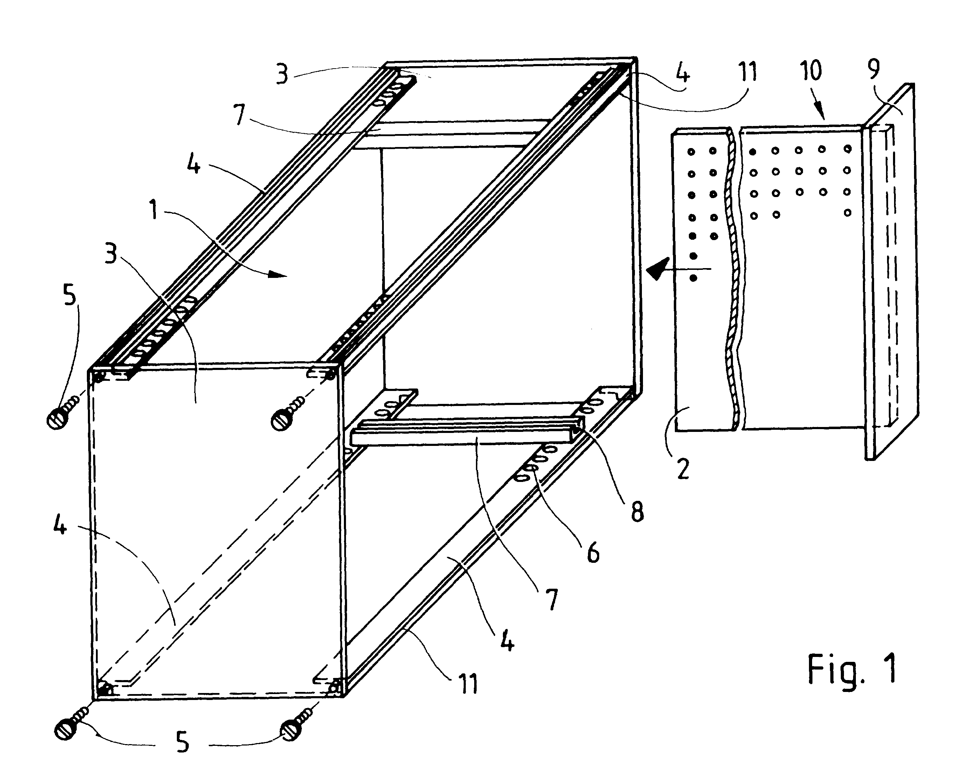

In Figur 1 ist ein Baugruppenträger 1 zur Aufnahme von Leiterkarten 2 mit (nicht dargestellten) elektronischen Bauelementen schematisch in einer perspektivischen Ansicht dargestellt. Der gezeigte Baugruppenträger 1 umfaßt zwei Seitenwände 3, vier Modulschienen 4, welche die Seitenwände 3 verbinden und an diesen mittels Befestigungsschrauben 5 befestigt sind. Die Modulschienen 4 weisen in einem bestimmten Abstandsraster Langlöcher 6 auf, in welche obere und untere Führungsschienen 7 eingesteckt werden können. Die Führungsschienen 7 sind jeweils mit einer Führungsnut 8 zur Aufnahme der Leiterkarten 2 versehen. Die dargestellte Leiterkarte 2, die aus Gründen der Übersichtlichkeit verkürzt abgebildet ist, ist fest mit einer Frontplatte 9 verbunden und bildet mit dieser zusammen eine Steckbaugruppe 10. Die Frontplatte 9 kann an den vorderen Modulschienen 4 jeweils mittels einer offenen Nut 11 befestigt werden.

In Figur 1 nicht dargestellt sind Deck- und Bodenplatten sowie eine rückwärtige Haube und weitere Frontplattenelemente, die für eine Abschirmung gegen hochfrequente Störfelder gegebenenfalls vorhanden sein müßten.

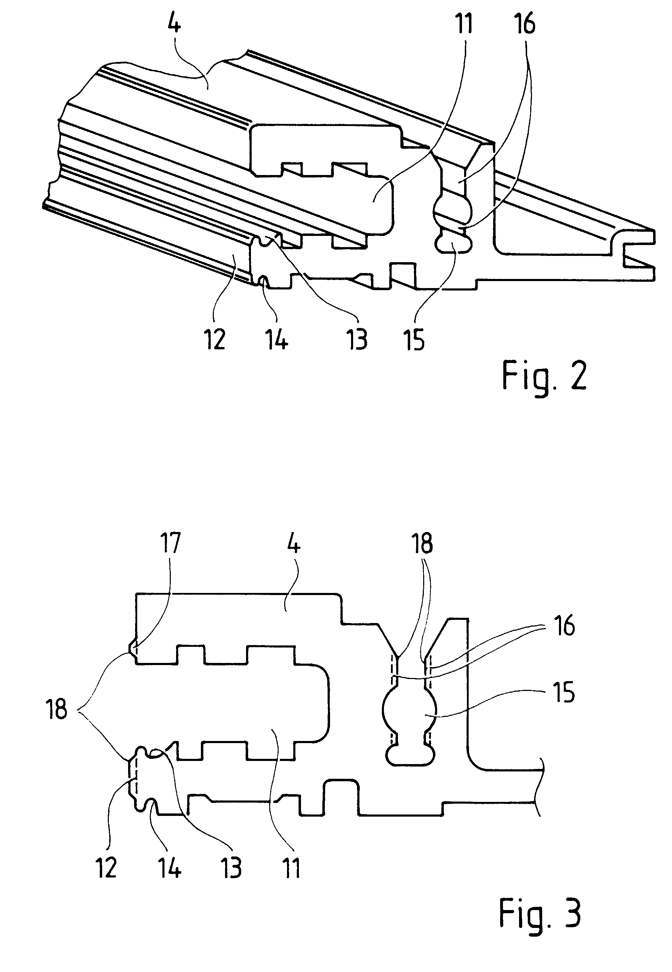

Figur 2 zeigt eine perspektivische Darstellung einer Modulschiene 4. Diese weist eine nach vorne offene Nut 11 auf, in deren inneren erweiterten Bereich ein hier nicht dargestellter Gewindelochstreifen eingeschoben wird. Unterhalb der Nut 11 besitzt die Modulschiene 4 eine blankgefräste Anlagefläche 12. Hinter der Anlagefläche 12 sind eine obere Eingriffsnut 13 und eine untere Eingriffsnut 14 angeordnet. Zusätzlich zur nach vorne offenen Nut 11 befindet sich in der Modulschiene 4 eine Befestigungsnut 15 zur Befestigung einer Deckplatte. Auch diese Befestigungsnut 15 enthält blankgefräste Kontaktflächen 16.

Figur 3 zeigt die Seitenansicht der in Figur 2 dargestellten Modulschiene 4, jedoch als Zwischenprodukt, und zwar noch vor dem Blankfräsen der Anlagefläche 12 und der Kontaktflächen 16. Auf der Anlagefläche 12 sowie einer weiteren Kontaktfläche 17, welche beide an der Vorderseite der Modulschiene 4 angeordnet und mit durchbrochenen Linien angedeutet sind, sind Überhöhungen 18 zu erkennen. Nach kontinuierlichem Abfräsen dieser Überhöhungen 18 sind die Anlagefläche 12 und die weitere Kontaktfläche 17 ohne Eloxalschicht, welche ansonsten die Oberfläche der Modulschiene 4 überdeckt. Entsprechend sind die Kontaktflächen 16 der Befestigungsnut 15, welche ebenfalls mit durchbrochenen Linien angedeutet sind, mit Überhöhungen 18 versehen, welche zur Kontaktierung der nicht dargestellten Deckplatte mit der Modulschiene 4 weggefräst werden.

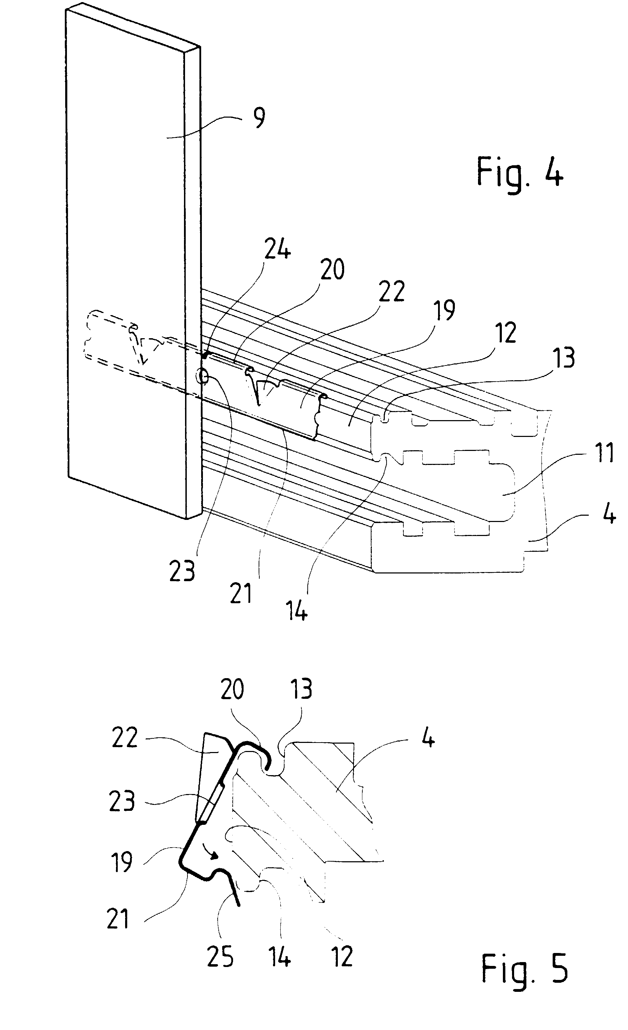

Figur 4 zeigt schematisch die Kontaktierung einer Modulschiene 4 mit einer Frontplatte 9 einer Steckbaugruppe 10. Hierbei ist eine Modulschiene 4 gezeigt, welche die vordere untere Ecke eines Baugruppenträgers 1 bildet; deswegen ist deren Profilierung gegenüber der in den Figuren 2 und 3 dargestellten, vorderen oberen Modulschiene 4 spiegelbildlich angeordnet. Wie in den Figuren 2 und 3 ist auch die in Figur 4 dargestellte Modulschiene 4 mit einer nach vorne offenen Nut 11 zur Aufnahme eines Gewindelochstreifens versehen, welcher in den inneren erweiterten Bereich der Nut 11 einschiebbar ist. Eine (nicht dargestellte) Befestigungsschraube kann durch eine Befestigungsöffnung in der Frontplatte 9 hindurchgeführt und in ein Gewindeloch des Gewindelochstreifens eingeschraubt werden.

Oberhalb der Nut 11 weist die Modulschiene 4 eine blankgefräste Anlagefläche 12 auf. Hinter dieser Anlagefläche 12 sind eine obere Eingriffsnut 13 und eine untere Eingriffsnut 14 zu erkennen. Auf der Anlagefläche 12 sitzt ein Kontaktfederband 19, welches aus einem ebenen Edelstahlblech besteht und dessen oberer Rand 20 und unterer Rand 21 nach innen abgebogen sind, so daß sie in die obere Eingriffsnut 13 bzw. in die untere Eingriffsnut 14 eingreifen. Das Kontaktfederband 19 ist mit der Modulschiene 4 also lediglich dadurch verbunden, daß es auf die Anlagefläche 12 aufgeschnappt ist.

Das Kontaktfederband 19 ist mit nach vorne weisenden Ausbrechungen 22 versehen, welche den elektrischen Kontakt mit der Frontplatte 9 herstellen, sowie mit zur Anlagefläche 12 zeigenden Kontaktkrallen 23, welche den elektrischen Kontakt mit der Modulschiene 4 gewährleisten. Die Ausbrechungen 22 bestehen jeweils aus einem vertikalen Einschnitt und zwei davon ausgehenden, dreieckförmig abgebogenen Federblättern mit scharfkantigen Rändern. Beim Andrücken der Frontplatte 9 an die Modulschiene 4 werden die Federblätter der Ausbrechungen 22 elastisch verformt, wobei deren scharfkantige Ränder eine eventuell vorhandene Oxidschicht der Frontplatte 9 durchdringen. Die Kontaktkralle 23 ist im dargestellten Beispiel als scharfkantige Materialausstülpung ausgebildet und sitzt an der Sollbruchstelle 24 zwischen zwei identischen Abschnitten des Kontaktfederbandes 19.

Figur 5 illustriert das Aufschnappen eines Kontaktfederbandes 19 auf eine Modulschiene 4. Das Kontaktfederband 19 mit Ausbrechungen 22 und Kontaktkrallen 23 wird zunächst mit dem zweifach abgekanteten oberen Rand 20 in die obere Eingriffsnut 13 der Modulschiene 4 eingesetzt. Danach wird der ebenfalls zweifach abgekantete untere Rand 21 des Kontaktfederbandes mit Hilfe einer Auflaufschräge 25 in die untere Eingriffsnut 14 eingeschnappt, so daß sich im Ergebnis das Kontaktfederband 19 auf die Anlagefläche 12 der Modulschiene 4 anlegt und durch die Eigenelastizität festgehalten wird.

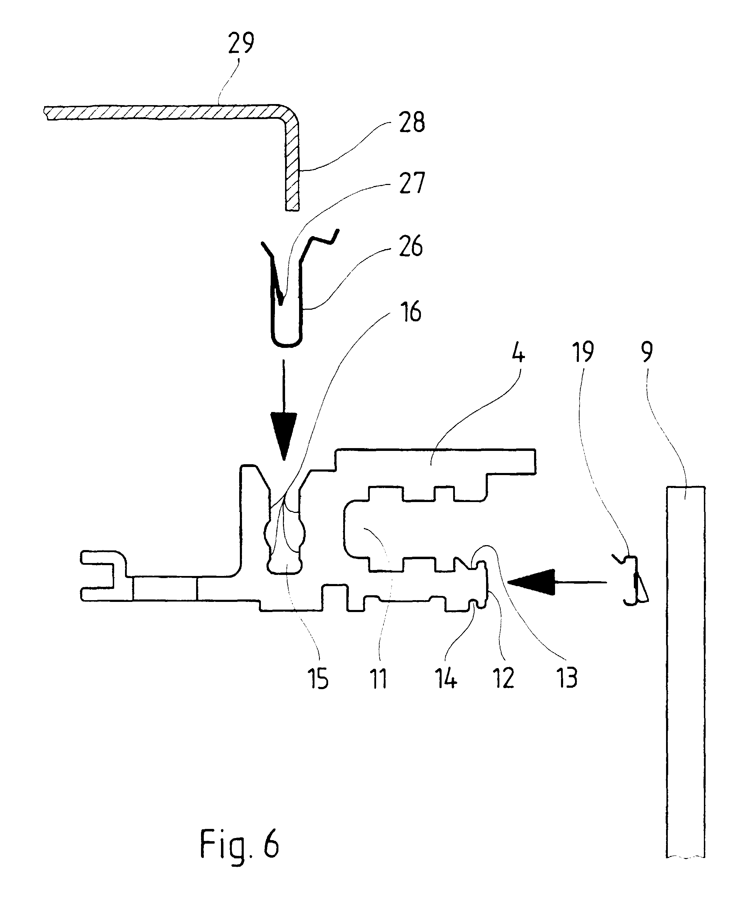

In Figur 6 ist die Seitenansicht einer vorderen oberen Modulschiene 4 dargestellt, welche neben der Nut 11 zur Befestigung der Frontplatte 9 auch eine Befestigungsnut 15 aufweist. Zur hochfrequenzdichten Abschirmung wird auf die Anlagefläche 12 ein Kontaktfederband 19 aufgeschnappt, welches die Kontaktierung der Frontplatte 9 mit der Modulschiene 4 gewährleistet. In die Befestigungsnut 15 wird ein Federelement 26 klemmend eingesetzt, welches an den blankgefrästen Kontaktflächen 16 der Modulschiene 4 anliegt. Das Federelement 26 weist eine nach innen abgespreizte Federzunge 27 auf, mittels der eine abgekantete Randleiste 28 eines Deckblechs 29 federnd kontaktiert wird. Über das Federelement 26 wird also das Deckblech 29 mit der Modulschiene 4 elektrisch leitend verbunden.

### Zusammenstellung der Bezugszeichen

- 1: Baugruppenträger
- 2: Leiterkarte
- 3: Seitenwände
- 4: Modulschienen
- 5: Befestigungsschrauben
- 6: Langlöcher
- 7: Führungsschienen
- 8: Führungsnut
- 9: Frontplatte
- 10: Steckbaugruppe
- 11: Nut (in 4)
- 12: Anlagefläche
- 13: obere Eingriffsnut
- 14: untere Eingriffsnut
- 15: Befestigungsnut
- 16: Kontaktflächen
- 17: weitere Kontaktfläche
- 18: Überhöhungen
- 19: Kontaktfederband
- 20: oberer Rand (von 19)
- 21: unterer Rand (von 19)
- 22: Ausbrechungen
- 23: Kontaktkralle
- 24: Sollbruchstelle
- 25: Auflaufschräge
- 26: Federelement
- 27: Federzunge
- 28: Randleiste
- 29: Deckblech

## Patentansprüche

1. Baugruppenträger für auf Führungsschienen einschiebbare Leiterkarten mit elektrischen oder elektronischen Bauelementen, umfassend:
- zwei parallele Seitenwände (3);
- wenigstens vier parallel verlaufende Modulschienen (4) aus eloxiertem Aluminium oder einer eloxierten Aluminiumlegierung, welche die Seitenwände (3) verbinden und die Führungsschienen (7) tragen;
- an jeder vorderen Modulschiene (4) wenigstens eine Anlagefläche (12) für eine oder mehrere Frontplatten (9),
- wobei die Anlageflächen (12) zumindest bereichsweise durch mechanisches Abtragen von ihrer Eloxalschicht befreit sind.

2. Baugruppenträger nach Anspruch 1, **gekennzeichnet** durch Überhöhungen (18) auf den Anlageflächen (12), die durch mechanisches Abtragen beseitigt wurden, so daß die Anlageflächen (12) in den Bereichen der Überhöhungen (18) von ihrer Eloxalschicht befreit sind.

3. Baugruppenträger nach einem der Ansprüche 1 oder 2, dadurch **gekennzeichnet** , daß die Modulschienen (4) als Strangpreßprofile ausgebildet sind.

4. Baugruppenträger nach einem der Ansprüche 1 bis 3, dadurch **gekennzeichnet** daß die vorderen Modulschienen (4) je eine zur Vorderseite des Baugruppenträgers (1) weisende offene Nut (11) zur Aufnahme eines Gewindelochstreifens aufweisen.

5. Baugruppenträger nach einem der Ansprüche 1 bis 4, dadurch **gekennzeichnet** , daß Kontaktfederbänder (19) auf die Anlageflächen (12) der vorderen Modulschienen (4) aufsteckbar sind.

6. Baugruppenträger nach Anspruch 5, dadurch **gekennzeichnet** , daß die Kontaktfederbänder (19) einen im wesentlichen U-förmigen Querschnitt aufweisen.

7. Baugruppenträger nach Anspruch 6, dadurch **gekennzeichnet** , daß die Kontaktfederbänder (19) nach innen abgebogene Klemmränder tragen.

8. Baugruppenträger nach einem der Ansprüche 5 bis 7, dadurch **gekennzeichnet** , daß die Kontaktfederbänder (19) aus einer Anzahl gleicher Abschnitte bestehen, zwischen denen jeweils eine Sollbruchstelle (24) angeordnet ist.

9. Baugruppenträger nach einem der Ansprüche 5 bis 8, dadurch **gekennzeichnet** , daß die vorderen Modulschienen (4) hinter ihren Anlageflächen (12) je eine obere Eingriffsnut (13) und eine untere Eingriffsnut (14) aufweisen, wobei die Kontaktfederbänder (19) durch beidseitiges Hintergreifen der Anlageflächen (12) in die Eingriffsnuten (13, 14) einrasten.

10. Baugruppenträger nach Anspruch 9, dadurch **gekennzeichnet** , daß die Kontaktfederbänder (19) im wesentlichen aus ebenen Metallblechen bestehen, deren obere und untere Ränder (20, 21) derart abgebogen sind, daß sie in die jeweiligen Eingriffsnuten (13, 14) der Modulschienen (4) eingreifen.

11. Baugruppenträger nach einem der Ansprüche 1 bis 10, dadurch **gekennzeichnet** , daß die Kontaktfederbänder (19) eine Anzahl von Kontaktelementen aufweisen.

12. Baugruppenträger nach Anspruch 11, dadurch **gekennzeichnet** , daß die Kontaktfederbänder (19) eine Anzahl von federnd zur Vorderseite des Baugruppenträgers (1) weisende Ausbrechungen (22) sowie eine Anzahl von zur Anlagefläche (12) weisende Kontaktkrallen (23) tragen.

13. Baugruppenträger nach einem der Ansprüche 1 bis 12, dadurch **gekennzeichnet** , daß die Modulschienen (4) Befestigungsnuten (15) aufweisen, deren Innenflächen zumindest bereichsweise durch mechanisches Abtragen von ihrer,Eloxalschicht befreit sind.

14. Baugruppenträger nach Anspruch 13, **gekennzeichnet** durch Überhöhungen (18) in den Befestigungsnuten (15), die durch mechanisches Abtragen beseitigt wurden, so daß die Befestigungsnuten (15) in den Bereichen der Überhöhungen (18) von ihrer Eloxalschicht befreit sind.

15. Baugruppenträger nach einem der Ansprüche 13 oder 14, dadurch **gekennzeichnet** , daß Federelemente (26) vorgesehen sind, die in die Befestigungsnuten (15) klemmend einsetzbar sind, um die Modulschienen (4) mit Randleisten (28) eines Deckblechs (29) oder eines Bodenblechs zu kontaktieren.

## Claims

1. Sub-rack for printed circuit boards, which can be pushed in on guide rails, with electrical or electronic components, comprising:
- two parallel side walls (3);
- at least four module rails (4), which extend in parallel, of anodized aluminium or an anodized aluminium alloy, which connect the side walls (3) and bear the guide rails (7);
- at least one locating face (12) for one or more front panels (9) at each front module rail (4),
- wherein the locating faces (12) are freed from their anodized coating, at least in regions, by mechanical abrasion.

2. Sub-rack according to claim 1, characterised by cambers (18) on the locating faces (12) which have been removed by mechanical abrasion, so that the locating faces (12) are freed from their anodized coating in the regions of the cambers (18).

3. Sub-rack according to claim 1 or 2, characterised in that the module rails (4) are formed as extruded sections.

4. Sub-rack according to any one of claims 1 to 3, characterised in that the front module rails (4) each comprise an open groove (11) pointing towards the front side of the sub-rack (1) to accommodate a threaded hole strip.

5. Sub-rack according to any one of claims 1 to 4, characterised in that contact spring strips (19) can be pushed onto the locating faces (12) of the front module rails (4).

6. Sub-rack according to claim 5, characterised in that the contact spring strips (19) have a substantially U-shaped cross-section.

7. Sub-rack according to claim 6, characterised in that the contact spring strips (19) have inward bent clamping edges.

8. Sub-rack according to any one of claims 5 to 7, characterised in that the contact spring strips (19) consist of a number of like portions, between which a respective predetermined breaking point (24) is disposed.

9. Sub-rack according to any one of claims 5 to 8, characterised in that the front module rails (4) each comprise an upper engagement groove (13) and a lower engagement groove (14) behind their locating faces (12), wherein the contact spring strips (19) lock into the engagement grooves (13, 14) by engaging behind the locating faces (12) on both sides.

10. Sub-rack according to claim 9, characterised in that the contact spring strips (19) consist substantially of plane metal sheets, the upper and lower edges (20, 21) of which are bent such that they engage in the respective engagement grooves (13, 14) in the module rails (4).

11. Sub-rack according to any one of claims 1 to 10, characterised in that the contact spring strips (19) comprise a number of contact elements.

12. Sub-rack according to claim 11, characterised in that the contact spring strips (19) bear a number of break-out parts (22), which point resiliently towards the front side of the sub-rack (1), and a number of contact claws (23), which point towards the locating face (12).

13. Sub-rack according to any one of claims 1 to 12, characterised in that the module rails (4) comprise fastening grooves (15), the inner faces of which are freed from their anodized coating, at least in regions, by mechanical abrasion.

14. Sub-rack according to claim 13, characterised by cambers (18) in the fastening grooves (15) which have been removed by mechanical abrasion, so that the festening grooves (15) are freed from their anodized coating in the regions of the cambers (18).

15. Sub-rack according to claim 13 or 14, characterised in that spring elements (26) are provided which can be inserted in clamping fashion in the fastening grooves (15) in order to contact the module rails (4) with edge strips (28) of a cover plate (29) or a bottom plate.

## Revendications

1. Support de modules pour cartes imprimées à composants électriques ou électroniques pouvant être glissées sur des barres de guidage, comprenant :
- deux parois latérales parallèles (3),
- au moins quatre barres modulaires parallèles (4) en aluminium anodisé ou alliage d'aluminium anodisé qui relient les parois latérales (3) et portent les barres de guidage (7),
- sur chaque barre modulaire (4) avant, au moins une surface d'appui (12) pour une ou plusieurs platines avant (9),
- les surfaces d'appui (12) étant, au moins par endroits, débarrassées de leur couche anodisée par enlèvement mécanique.

2. Support de modules selon la revendication 1, caractérisé par des surélévations (18) sur les surfaces d'appui (12) qui ont été éliminées par enlèvement mécanique, de sorte que les surfaces d'appui (12) sont, dans les zones des surélévations (18), débarrassées de leur couche anodisée.

3. Support de modules selon l'une des revendications 1 et 2, caractérisé par le fait que les barres modulaires (4) sont constituées de profilés extrudés.

4. Support de modules selon l'une des revendications 1 à 3, caractérisé par le fait que les barres modulaires (4) avant présentent chacune une rainure ouverte (11) dirigée vers le côté avant du support de modules (1) et destinée à recevoir une bande à trous taraudés.

5. Support de modules selon l'une des revendications 1 à 4, caractérisé par le fait que des bandes élastiques de contact (19) peuvent être emboîtées sur les surfaces d'appui (12) des barres modulaires (4) avant.

6. Support de modules selon la revendication 5, caractérisé par le fait que les bandes élastiques de contact (19) présentent une section sensiblement en forme de U.

7. Support de modules selon la revendication 6, caractérisé par le fait que les bandes élastiques de contact (19) portent des bords de serrage recourbés vers l'intérieur.

8. Support de modules selon l'une des revendications 5 à 7, caractérisé par le fait que les bandes élastiques de contact (19) sont constituées d'un certain nombre de tronçons identiques entre lesquels se trouvent des endroits de rupture (24).

9. Support de modules selon l'une des revendications 5 à 8, caractérisé par le fait que les barres modulaires (4) avant présentent derrière chacune de leurs surfaces d'appui (12) une rainure d'engagement supérieure (13) et une rainure d'engagement inférieure (14), et les bandes élastiques de contact (19) s'enclenchent dans ces rainures (13, 14) en s'appliquant des deux côtés derrière les surfaces d'appui (12).

10. Support de modules selon la revendication 9, caractérisé par le fait que les bandes élastiques de contact (19) sont constituées essentiellement de morceaux de tôle métallique plans dont les bords supérieur et inférieur (20, 21) sont recourbés de façon telle qu'ils s'engagent dans les rainures d'engagement correspondantes (13, 14) des barres modulaires (4).

11. Support de modules selon l'une des revendications 1 à 10, caractérisé par le fait que les bandes élastiques de contact (19) présentent un certain nombre d'éléments de contact.

12. Support de modules selon la revendication 11, caractérisé par le fait que les bandes élastiques de contact (19) portent un certain nombre de cassures (22) dirigées élastiquement vers le côté avant du support de modules (1) et un certain nombre de griffes de contact (23) dirigées vers la surface d'appui (12).

13. Support de modules selon l'une des revendications 1 à 12, caractérisé par le fait que les barres modulaires (4) présentent des rainures de fixation (15) dont les surfaces intérieures sont, au moins par endroits, débarrassées de leur couche anodisée par enlèvement mécanique.

14. Support de modules selon la revendication 13, caractérisé par des surélévations (18) dans les rainures de fixation (15) qui ont été éliminées par enlèvement mécanique, de sorte que les rainures de fixation (15) sont, dans les zones des surélévations (18), débarrassées de leur couche anodisée.

15. Support de modules selon l'une des revendications 13 et 14, caractérisé par le fait qu'il est prévu des éléments élastiques (26) qu'on peut engager avec serrage dans les rainures de fixation (15) pour mettre les barres modulaires (4) en contact avec des rebords (28) d'une plaque de couverture (29) ou d'une plaque de fond.
